(19) **Europäisches Patentamt**
**European Patent Office**
**Office européen des brevets**

(11) **EP 4 788 108 A1**

(12) **EUROPEAN PATENT APPLICATION**

(43) Date of publication:
**05.08.2026 Bulletin 2026/32**

(51) International Patent Classification (IPC):
**H10N 60/01** (2023.01)      **H10N 60/80** (2023.01)
**H10N 69/00** (2026.01)

(21) Application number: **26153191.7**

(22) Date of filing: **21.01.2026**

(52) Cooperative Patent Classification (CPC):
**H10N 69/00; H10N 60/0912; H10N 60/805**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.01.2025 JP 2025012766**

(71) Applicant: **FUJITSU LIMITED**
**Kawasaki-shi, Kanagawa 211-8588 (JP)**

(72) Inventors:
• **DOTE, Aki**
  **Kawasaki-shi, 211-8588 (JP)**
• **SHIBA, Shoichi**
  **Kawasaki-shi, 211-8588 (JP)**
• **TAMATE, Shuhei**
  **Wako-shi, 351-0198 (JP)**

(74) Representative: **Haseltine Lake Kempner LLP**
**Cheapside House**
**138 Cheapside**
**London EC2V 6BJ (GB)**

(54) **QUANTUM DEVICE AND METHOD FOR MANUFACTURING QUANTUM DEVICE**

(57)  A quantum device having a plurality of quantum bits (1) connected to each other via coupling wiring lines (30), wherein each of the plurality of quantum bits includes: a Josephson junction device (4); and a quantum bit electrode (50) connected to one end of the Josephson junction device; and the quantum device including: a ground electrode (51) to which the other end of the Josephson junction device is connected; an insulating region (52) between the quantum bit electrode and the ground electrode; and a guard structure (54) that is provided along a portion of the coupling wiring line extending in the insulating region and is fixed to a ground potential.

FIG.5

**Description**

BACKGROUND

Technical Field

A certain aspect of the embodiments discussed herein is related to a quantum device and a method for manufacturing the quantum device.

Related Art

The following techniques are known as techniques related to quantum bits. WO 2021/245949 describes a quantum chip on which a coplanar line for coupling adjacent quantum bits is formed. The coplanar line has a central conductor and a ground electrode around the central conductor.
Japanese Patent Application Laid-Open (JP-A) No. 2023-63931 describes a configuration in which four coupling ports are provided on an outer periphery of an O-shaped quantum bit.
A two-quantum bit operation, which is one of gate operations of a quantum device, is a gate operation of applying a control signal to a control quantum bit adjacent to a target quantum bit that is subjected to state transition.
In the two-quantum bit operation, classical crosstalk (hereinafter referred to as crosstalk) becomes a problem. Crosstalk is a phenomenon in which a control signal leaks to a coupling wiring line connecting quantum bits and directly acts on the target quantum bit without passing through the control quantum bit.
In order to perform a two-quantum gate operation at high speed, it is effective to increase coupling strength between the control quantum bit and the target quantum bit. However, when the coupling strength between the quantum bits is increased, the crosstalk increases.
The disclosed technique has been made in view of the above points, and it is desirable to suppress an increase in crosstalk accompanying an increase in coupling strength between quantum bits.

SUMMARY

Accordingly, it is desirable to provide a quantum device and a method for manufacturing the quantum device to suppress an increase in crosstalk accompanying an increase in coupling strength between quantum bits.
According to an aspect of the embodiments, a quantum device according to the disclosed technique has a plurality of quantum bits connected to each other via coupling wiring lines. Each of the plurality of quantum bits includes a Josephson junction device and a quantum bit electrode connected to one end of the Josephson junction device. The quantum device includes a ground electrode to which the other end of the Josephson junction device is connected, an insulating region between the quantum bit electrode and the ground electrode, and a guard structure that is provided along a portion of the coupling wiring line extending in the insulating region and is fixed to a ground potential.
According to the disclosed technique, it is possible to suppress an increase in crosstalk accompanying an increase in coupling strength between quantum bits.

BRIEF DESCRIPTION OF THE DRAWINGS

Reference will now be made, by way of example only, to the following drawings, in which:

Fig. 1 is a plan view schematically illustrating an example of a configuration of a quantum device according to an embodiment of the disclosed technique.
Fig. 2 is an enlarged view illustrating one unit according to the embodiment of the disclosed technique.
Fig. 3 is an equivalent circuit diagram of an operation block according to the embodiment of the disclosed technique.
Fig. 4 is a cross-sectional view schematically illustrating a configuration of the quantum device according to the embodiment of the disclosed technique.
Fig. 5 is a plan view illustrating an example of a conductor pattern around a quantum bit according to the embodiment of the disclosed technique.
Fig. 6 is an equivalent circuit diagram illustrating a coupling state between two quantum bits to be subjected to a two-quantum gate operation.
Fig. 7A is a model diagram of a simulation.
Fig. 7B is a model diagram of a simulation.
Fig. 8 is a graph illustrating crosstalk performance.
Fig. 9 is a plan view illustrating an example of the conductor pattern around the quantum bit according to the embodiment of the disclosed technique.

Fig. 10 is a graph illustrating a relationship between a radius ratio and electric field concentration.

Fig. 11 is a plan view for describing a radius ratio.

Fig. 12 is a graph illustrating an electric field distribution on a path from a quantum bit electrode to a ground electrode.

Fig. 13A is a plan view illustrating an example of a manufacturing process for a quantum device according to the embodiment of the disclosed technique.

Fig. 13B is a plan view illustrating an example of a manufacturing process for a quantum device according to the embodiment of the disclosed technique.

Fig. 13C is a plan view illustrating an example of a manufacturing process for a quantum device according to the embodiment of the disclosed technique.

Fig. 13D is a plan view illustrating an example of a manufacturing process for a quantum device according to the embodiment of the disclosed technique.

Fig. 14 is a plan view illustrating a configuration in which a coupling wiring line is directly connected to a quantum bit electrode.

Fig. 15 is an equivalent circuit diagram corresponding to Fig. 14.

Fig. 16 is a plan view illustrating an example of a connection configuration between quantum bits whose electrode type is a Floating type.

Fig. 17 is an equivalent circuit diagram corresponding to Fig. 16.

## DETAILED DESCRIPTION OF THE INVENTION

Hereinafter, an example of an embodiment of the disclosed technique will be described with reference to the drawings. Note that, in the drawings, the same or equivalent components and parts are denoted by the same reference numerals, and redundant descriptions will be omitted.

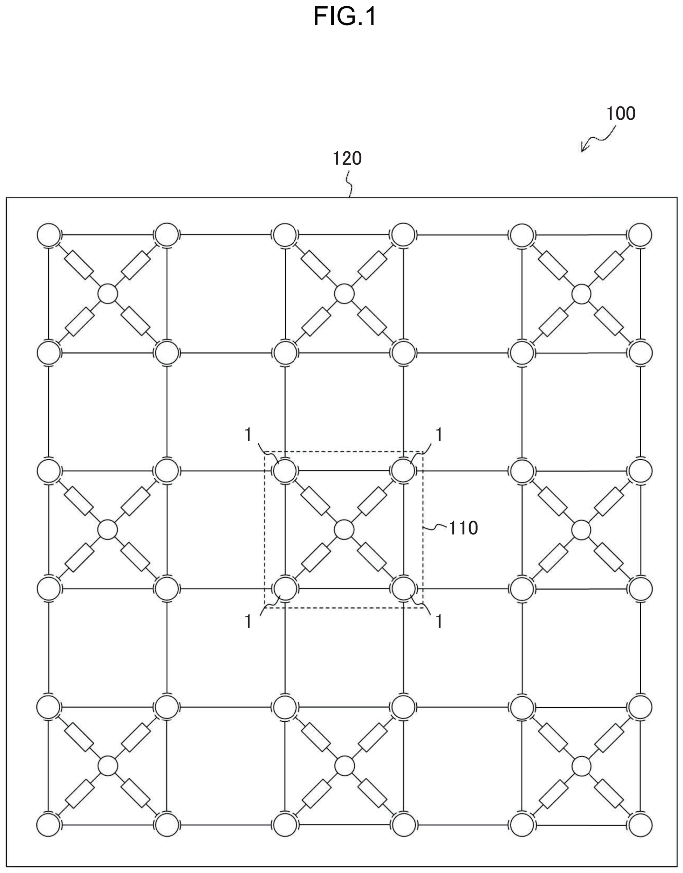

Fig. 1 is a plan view schematically illustrating an example of a configuration of a quantum device 100 according to the embodiment of the disclosed technique. The quantum device 100 has four quantum bits 1 as a unit 110. The quantum device 100 has a plurality of units 110 arranged in a grid pattern on a substrate 120.

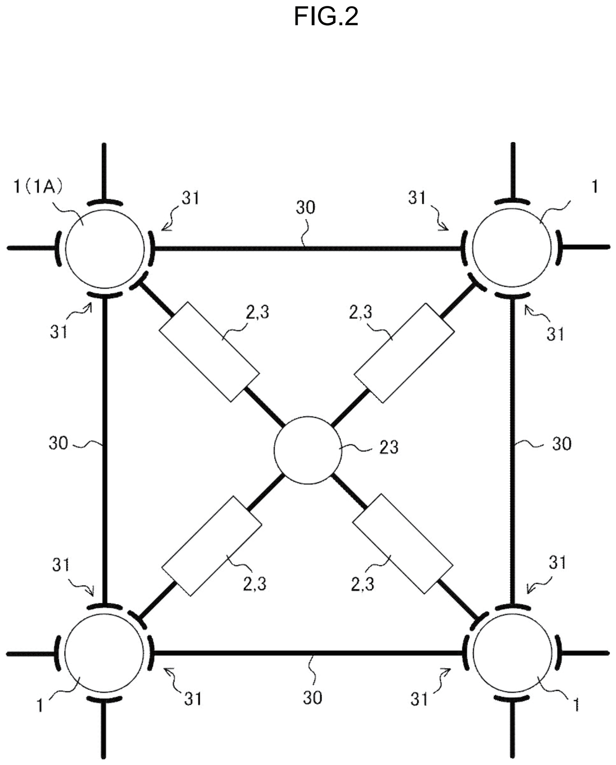

Fig. 2 is an enlarged view illustrating one of the units 110. The four quantum bits 1 constituting one unit 110 are arranged at positions corresponding to four vertexes of a square, and a read port 23 is arranged at the center of the square. One read port 23 is shared by four quantum bits 1. A resonator 2 and a filter 3 are provided on each path from the four quantum bits 1 to the read port 23. Each quantum bit 1 is connected to another adjacent quantum bit 1 via a coupling wiring line 30. The coupling wiring line 30 is connected to the quantum bit 1 via a capacitor 31 provided at an end thereof. In other words, the quantum bit 1 forms capacitive coupling with another adjacent quantum bit 1. The quantum bit 1 creates a quantum entangled state with another adjacent quantum bit 1 and performs a quantum operation.

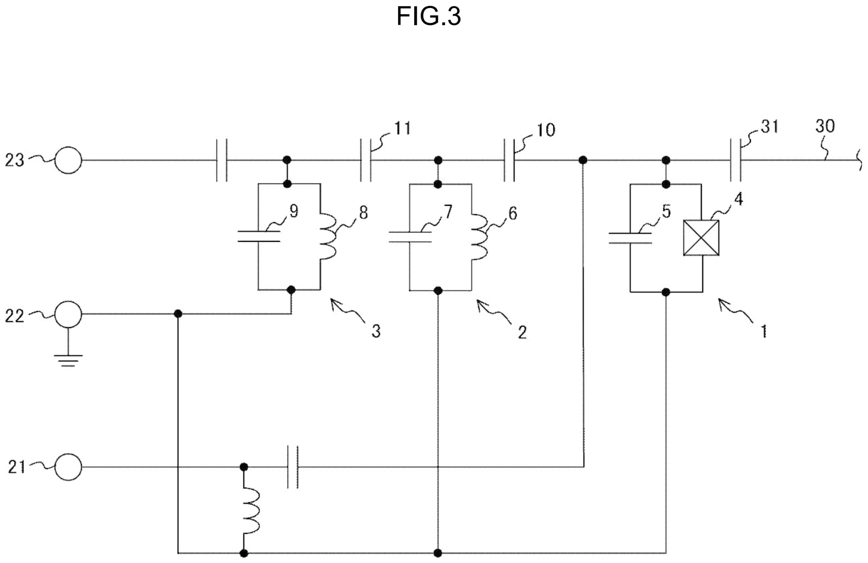

Fig. 3 is an equivalent circuit diagram of an operation block including one quantum bit 1, one resonator 2, and one filter 3. The quantum bit 1 is an element that forms a nonlinear two-level system using superconductivity and performs coherent quantum operations. The quantum bit 1 has a transmon in which a Josephson junction device 4 and a capacitor 5 are connected in parallel. The Josephson junction device 4 includes a pair of superconductor layers that exhibit superconductivity at a temperature equal to or lower than a predetermined critical temperature, and an extremely thin insulator layer having a thickness of about several nm sandwiched between the pair of superconductor layers. The superconductor layer may be, for example, aluminum, and the insulator layer may be, for example, aluminum oxide.

The resonator 2 is connected to the quantum bit 1 via a capacitor 10. The resonator 2 interacts with the quantum bit 1 to read out a response signal indicating the state of the quantum bit 1. The resonator 2 has a resonance circuit in which a superconducting inductor 6 and a capacitor 7 are connected in parallel. The filter 3 is connected to the resonator 2 via a capacitor 11. The filter 3 suppresses relaxation of a signal having a frequency of the quantum bit 1 to the read port 23. Similarly to the resonator 2, the filter 3 has a resonance circuit in which a superconducting inductor 8 and a capacitor 9 are connected in parallel.

A control port 21, a ground port 22, and the read port 23 are connected to the operation block. A control signal for controlling the quantum bit 1 is input to the control port 21. Note that, in Figs. 1 and 2, illustration of the control port 21 and the ground port 22 is omitted. The state of the quantum bit 1 is controlled by the control signal input to the control port 21. A response signal indicating the state of the quantum bit 1 is read out from the read port 23. The ground port 22 is connected to a ground electrode. The ground electrode is grounded to a common ground, and plays a role of keeping the ground electrode of each part of the operation block at a common potential. An electrode type of the quantum bit 1 according to the present embodiment is a Grounded type in which one electrode of the quantum bit 1 is fixed to a ground potential.

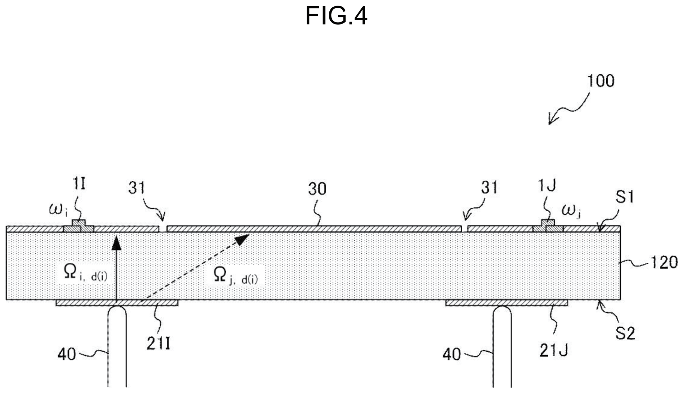

Fig. 4 is a cross-sectional view schematically illustrating a configuration of the quantum device 100. Fig. 4 illustrates two quantum bits 1I and 1J connected to each other via the coupling wiring line 30. The quantum device 100 includes a substrate 120. The quantum bits 1I and 1J and the coupling wiring line 30 connecting them are provided on a first surface S1 of the substrate 120. Control ports 21I and 21J are provided on a second surface S2 of the substrate 120 opposite to the first surface S1. The control port 21I is provided at a position overlapping the quantum bit 1I in plan view (that is, directly below the quantum bit 1I), and the control port 21J is provided at a position overlapping the quantum bit 1J in plan view (that is, directly below the quantum bit 1J). A control signal for a gate operation of transitioning the state of the quantum bit is input to the control ports 21I and 21J.

Fig. 4 illustrates a mode of a two-quantum bit operation, which is one of gate operations. The two-quantum bit operation is a gate operation of applying a control signal to a control quantum bit adjacent to a target quantum bit that is subjected to state transition. Fig. 4 illustrates a mode of the two-quantum bit operation, with the quantum bit 1J as a target quantum bit and the quantum bit 1I as a control quantum bit. A contact probe 40 is brought into contact with the control port 21I corresponding to the quantum bit 1I, which is a control quantum bit, and a control signal having a frequency equal to a resonance frequency $\omega_j$ of the quantum bit 1J, which is a target quantum bit, is input to the control port. Note that a resonance frequency $\omega_i$ of the quantum bit 1I and the resonance frequency $\omega_j$ of the quantum bit 1J are different from each other ($\omega_i \neq \omega_j$).

In the two-quantum bit operation, classical crosstalk (hereinafter referred to as crosstalk) becomes a problem. Crosstalk is a phenomenon in which a control signal leaks to the coupling wiring line 30 and directly acts on the target quantum bit without passing through the control quantum bit. Crosstalk $X_{ji}$ is defined by the following Formula (1). In Formula (1), $\Omega_{i,d(i)}$ is the Rabi frequency of the control quantum bit as viewed from the control port, $\Omega_{j,d(i)}$ is the Rabi frequency of the target quantum bit, representing leakage from the control port to the coupling wiring line 30, and Formula (1) corresponds to a power ratio expressed by a decibel unit. In a case in which a value of the crosstalk $X_{ji}$ defined by Formula (1) is excessively large, the two-quantum bit operation may be incomplete.

[Formula 1]

$$X_{ij} = 20 log \left( \frac{\Omega_{j,d(i)}}{\Omega_{i,d(i)}} \right) \quad \cdot \cdot \cdot \quad (1)$$

In order to perform the two-quantum gate operation at high speed, it is effective to increase the coupling strength between the control quantum bit and the target quantum bit (in other words, the coupling strength between the quantum bit 1 and the coupling wiring line 30). However, when the coupling strength between the quantum bits is increased, the crosstalk $X_{ji}$ increases. The quantum device 100 according to the embodiment of the disclosed technique suppresses an increase in crosstalk accompanying an increase in coupling strength between quantum bits by devising a conductor pattern around the quantum bit. Details thereof will be described below.

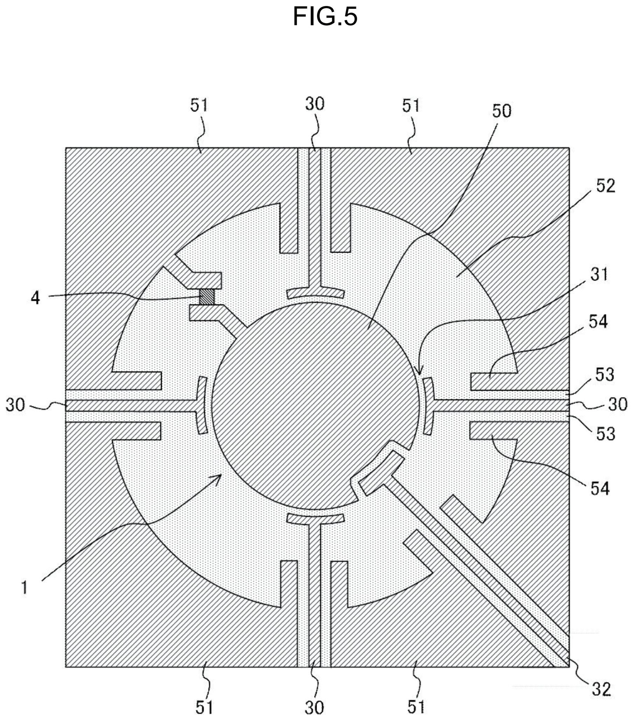

Fig. 5 is a plan view illustrating an example of a conductor pattern around the quantum bit 1. The quantum bit 1 includes a Josephson junction device 4 and a quantum bit electrode 50 connected to one end of the Josephson junction device 4. The quantum bit electrode 50 has a substantially circular outer shape.

A ground electrode 51 fixed to the ground potential extends around the quantum bit electrode 50. The other end of the Josephson junction device 4 is connected to the ground electrode 51. In other words, one of the pair of superconductor layers constituting the Josephson junction device 4 is connected to the quantum bit electrode 50, and the other is connected to the ground electrode 51. An edge of the ground electrode 51 facing the quantum bit electrode 50 has a substantially circular shape concentric with the quantum bit electrode 50. An insulating region 52 having a substantially annular shape extends between the quantum bit electrode 50 and the ground electrode 51.

The ground electrode 51 is provided with an open region 53 through which the coupling wiring line 30 passes. Fig. 5 illustrates four coupling wiring lines 30 extending from each of the other four quantum bits adjacent to the quantum bit 1 toward the quantum bit electrode 50. Each of the coupling wiring lines 30 passes through the open region 53, extends into the insulating region 52, and terminates near the quantum bit electrode 50. A capacitor 31 for forming capacitive coupling with an adjacent quantum bit is constituted by a T-shaped pattern formed at a terminal end of the coupling wiring line 30.

A guard structure 54 is provided in association with the coupling wiring line 30. The guard structure 54 has an effect of suppressing leakage of the control signal input to the control port 21 to the coupling wiring line 30 (crosstalk). The guard structure 54 is a structural portion constituted by a conductor fixed to the ground potential, and is provided along a portion of the coupling wiring line 30 extending in the insulating region 52. The guard structure 54 is constituted by a portion protruding from the edge of the ground electrode 51 facing the quantum bit electrode 50 toward the quantum bit electrode 50. The guard structure 54 has a pair of conductor pieces sandwiching the coupling wiring line 30 therebetween. The guard structure 54 is provided so as to extend the open region 53 of the ground electrode 51 to the insulating region 52.

A read wiring line 32 is a wiring line for guiding a response signal from the quantum bit 1 to the read port 23. The read wiring line 32 passes through the open region 53 of the ground electrode 51 and the insulating region 52 and extends into the inside of an arc forming the outer shape of the quantum bit electrode 50. A capacitor is constituted by a T-shaped pattern formed at the terminal end of the read wiring line 32. The guard structure 54 is provided in association with not only the coupling wiring line 30 but also the read wiring line 32.

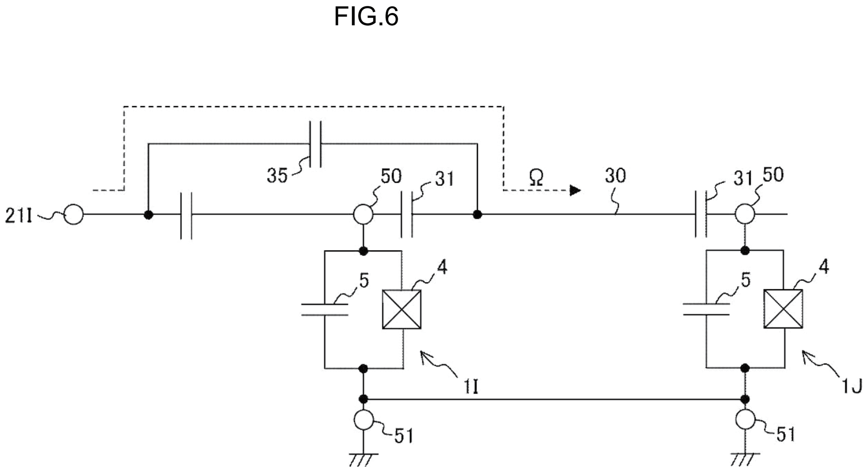

Fig. 6 is an equivalent circuit diagram illustrating a coupling state between two quantum bits 1I and 1J to be subjected to the two-quantum gate operation. A control signal $\Omega$ input to the control port 21I corresponding to the quantum bit 1I, which is a control quantum bit, leaks through a parasitic capacitor 35 formed between the control port 21I and the coupling wiring line 30. By providing the guard structure 54 fixed to the ground potential along the coupling wiring line 30 near the coupling wiring line 30, a capacitance of the parasitic capacitor 35 can be substantially reduced. As a result, it is possible to suppress leakage of the control signal $\Omega$ input to the control port 21I to the coupling wiring line 30 (crosstalk).

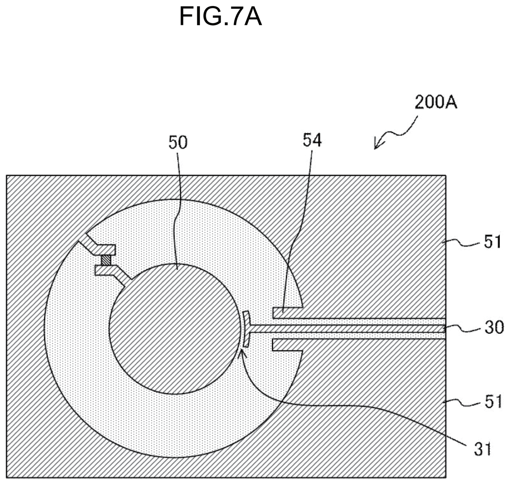

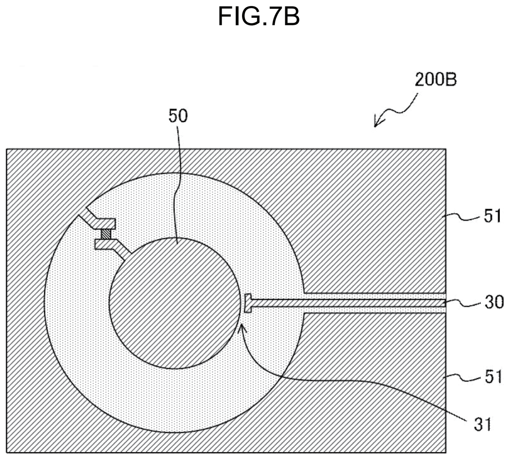

In order to confirm the effect of crosstalk suppression by the guard structure 54, electromagnetic field simulations were performed for each model illustrated in Figs. 7A and 7B. A model 200A illustrated in Fig. 7A has the guard structure 54, and a model 200B illustrated in Fig. 7B does not have the guard structure 54. Further, in the model 200A, a length of the T-shaped pattern at the terminal end of the coupling wiring line 30 is longer than that in the model 200B, in order to increase the coupling strength between the quantum bits compared to the model 200B. In other words, the capacitance of the capacitor 31 of the model 200A is larger than the capacitance of the capacitor 31 of the model 200B.

The coupling strength between the quantum bits obtained for each of the model 200A and the model 200B and the crosstalk are illustrated in Table 1 below. The crosstalk is defined by Formula (1). The coupling strength between the quantum bits was obtained by the electromagnetic field simulation. Although the model 200A with the guard structure 54 has a higher coupling strength between the quantum bits than the model 200B without the guard structure 54, the crosstalk is the same as that of the model 200B. In other words, by providing the guard structure 54, an increase in crosstalk accompanying an increase in coupling strength between quantum bits is suppressed.

[Table 1]

| Pattern | Coupling strength between quantum bits [MHz] | Crosstalk [dB] |
|---|---|---|
| With guard structure | 12.9 | -45.1 |
| Without guard structure | 10.8 | -45.1 |

The shorter a length l of the guard structure 54 in a protruding direction from the ground electrode 51, the greater the crosstalk, and the longer the length 1, the lower the coupling strength between the quantum bits. Further, a theoretical minimum value of the crosstalk is proportional to the coupling strength between the quantum bits. Therefore, for the length l of the guard structure 54 in the protruding direction from the ground electrode 51, there is an optimum value at which the crosstalk and the coupling strength between the quantum bits can be balanced. Therefore, the optimum value of the length l of the guard structure 54 in the protruding direction from the ground electrode 51 was examined.

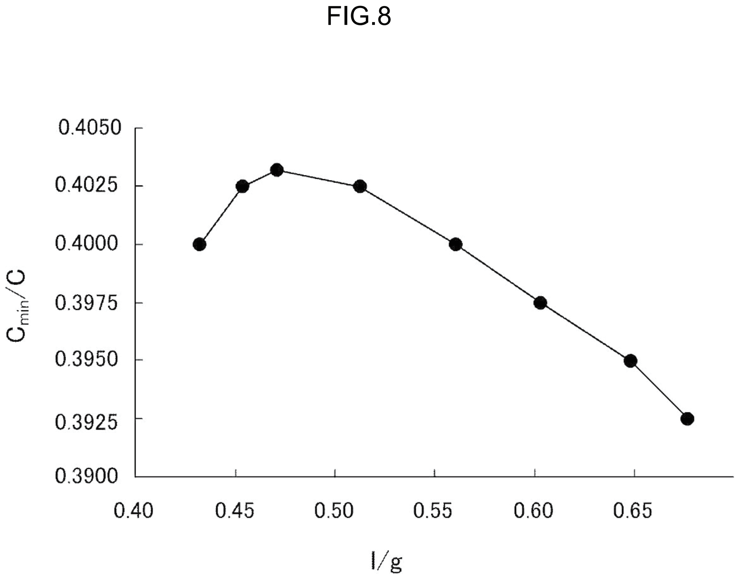

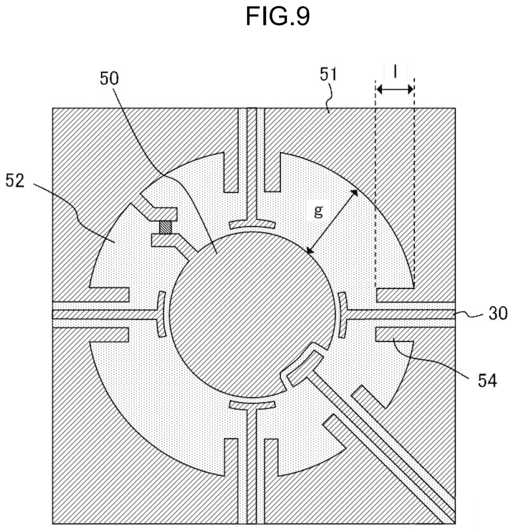

The crosstalk was calculated for a plurality of models in which the lengths l of the guard structure 54 in the protruding direction from the ground electrode 51 were made different. Fig. 8 is a graph illustrating crosstalk performance of each of the models. In the graph illustrated in Fig. 8, the horizontal axis represents a ratio l/g of the length l of the guard structure 54 in the protruding direction to a distance g between the quantum bit electrode 50 and the ground electrode 51 (see Fig. 9), and the vertical axis represents a ratio $(C_{min}/C)$ of a theoretical minimum value $C_{min}$ of the crosstalk to a crosstalk value C calculated in the model. The distance g corresponds to a width of the insulating region 52. A maximum value of $C_{min}/C$ is 1, and a larger value indicates a better balance between the crosstalk and the coupling strength between the quantum bits. By setting the ratio of the length l of the guard structure 54 in the protruding direction to the distance g between the quantum bit electrode 50 and the ground electrode 51 to be from 0.45 to 0.55, a balance between the crosstalk and the coupling strength between the quantum bits can be achieved.

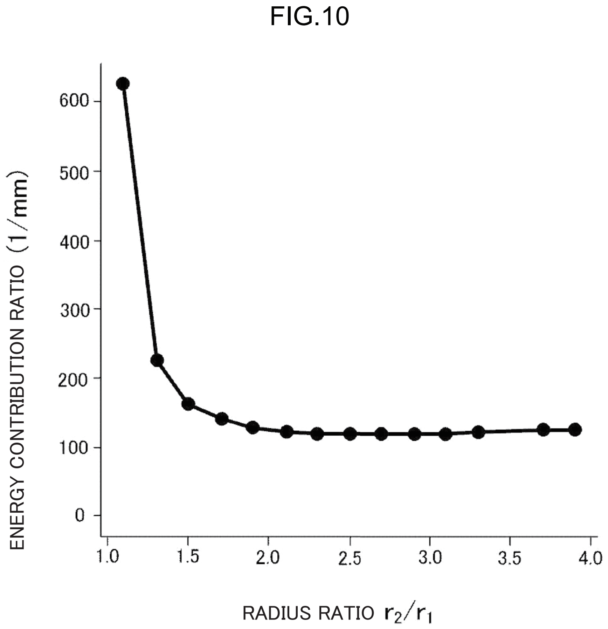

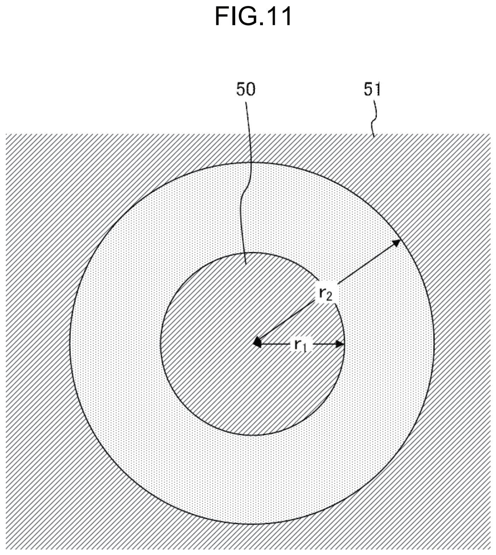

In a case in which the distance between the quantum bit electrode 50 and the ground electrode 51 is excessively short, the performance of the quantum bit 1 is deteriorated due to electric field concentration on surface electrodes. Therefore, the distance between the quantum bit electrode 50 and the ground electrode 51 was examined. An energy contribution ratio of the electrode surface, which is an index of electric field concentration, was calculated for a plurality of models in which the distances between the quantum bit electrode 50 and the ground electrode 51 were made different. Fig. 10 is a graph illustrating the energy contribution ratio of the electrode surface of each of the models. In the graph illustrated in Fig. 10, the horizontal axis represents a ratio $r_2/r_1$ of a radius $r_2$ of a circle defined by the edge of the ground electrode 51 facing the quantum bit electrode 50 to a radius $r_1$ of the quantum bit electrode 50 (see Fig. 11), and the vertical axis represents the energy contribution ratio of the electrode surface. As illustrated in Fig. 11, the quantum bit electrode 50 has a circular shape with a radius of $r_1$, and the edge of the ground electrode 51 facing the quantum bit electrode 50 has a circular shape that is concentric with the quantum bit electrode 50 and has a radius of $r_2$. From the graph illustrated in Fig. 10, the radius ratio $r_2/r_1$ needs to be sufficiently large in order to avoid electric field concentration, and is preferably 2 or more in the present embodiment.

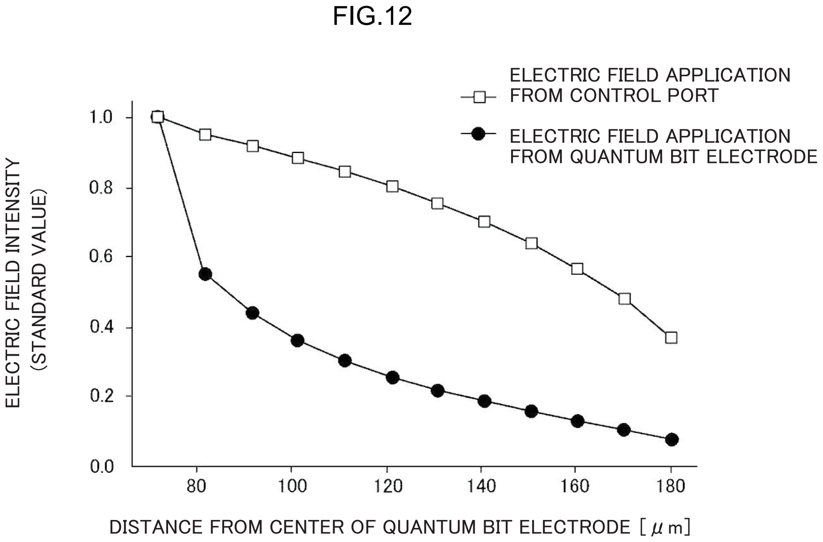

A coupling position of the coupling wiring line 30 relative to the quantum bit electrode 50 was examined. Fig. 12 is a graph illustrating an electric field distribution on a path from the quantum bit electrode 50 to the ground electrode 51. In the graph illustrated in Fig. 12, the horizontal axis represents the distance from the center of the quantum bit electrode 50, and the vertical axis represents a standardized electric field intensity. Fig. 12 illustrates a case in which an electric field is applied from the control port 21 and a case in which an electric field is applied from the quantum bit electrode 50.

The electric field applied from the quantum bit electrode 50 is concentrated at the center of the quantum bit electrode 50. This means that the terminal end of the coupling wiring line 30 needs to be brought close to the quantum bit electrode 50 in order to increase the coupling strength between the quantum bits. On the other hand, the electric field applied from the control port 21 decreases as the distance from the center of the quantum bit electrode 50 increases, but its change is gradual. For this reason, the control signal input to the control port 21 is also coupled to an arm portion of the coupling wiring line 30, which means that it is difficult to avoid leakage of the control signal (crosstalk). According to the quantum device 100 of the present embodiment, it is possible to suppress the inevitably occurring crosstalk by the guard structure 54 in which the ground electrode on the arm portion of the coupling wiring line 30 is extended.

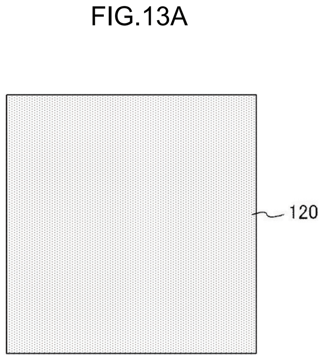

Hereinafter, a method for manufacturing the quantum device 100 will be described. Figs. 13A to 13D are plan views illustrating an example of manufacturing processes of the quantum device 100.

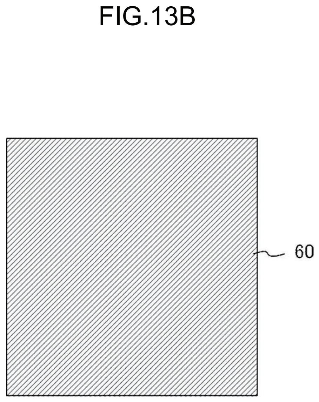

First, a substrate 120 is prepared. As a material of the substrate 120, for example, a silicon substrate with a thickness of about 300 $\mu$m can be used (Fig. 13A). Next, a conductive film 60 with a thickness of about 100 nm is formed on both surfaces of the substrate 120 by using, for example, a sputtering method, plasma chemical vapor deposition (CVD), or an ion plating method. As the material of the conductive film 60, for example, Nb, Al, Ta, or TiN can be used (Fig. 13B).

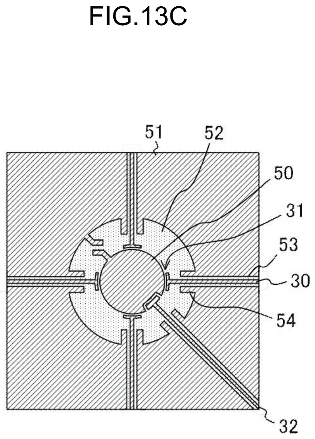

Next, a resist mask (not illustrated) is formed on the surface of the conductive film 60, and the conductive film 60 is patterned by partially etching the conductive film 60 through the resist mask. As a result, a quantum bit electrode 50, a ground electrode 51, a coupling wiring line 30, a read wiring line 32, and a guard structure 54 are formed on the surface of the substrate 120 (Fig. 13C). On a back surface of the substrate 120, a control port 21 is formed at a position overlapping the quantum bit electrode 50.

The quantum bit electrode 50 is patterned into a substantially circular shape. The ground electrode 51 is patterned so as to extend around the quantum bit electrode 50. Between the quantum bit electrode 50 and the ground electrode 51, an insulating region 52 for separating these electrodes is formed. In the ground electrode 51, an open region 53 is formed through which the coupling wiring line 30 passes. The coupling wiring line 30 is patterned so as to pass through the open region 53, extend into the insulating region 52, and terminate near the quantum bit electrode 50. A capacitor 31 for forming capacitive coupling with an adjacent quantum bit is constituted by a T-shaped pattern formed at a terminal end of the coupling wiring line 30.

The guard structure 54 is formed along both side surfaces of the portion of the coupling wiring line 30 extending in the insulating region 52. The guard structure 54 is constituted by a portion protruding from the edge of the ground electrode 51 facing the quantum bit electrode 50 toward the quantum bit electrode 50.

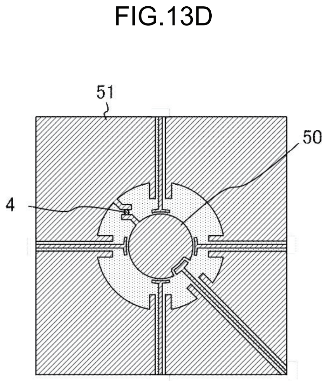

Next, a Josephson junction device 4 is formed on the surface of the substrate 120 (Fig. 13D). One end of the Josephson junction device 4 is connected to the quantum bit electrode 50, and the other end is connected to the ground electrode 51. The Josephson junction device 4 is formed through, for example, a step of forming a lower electrode (not illustrated) containing Al on the surface by a vapor deposition method, a step of forming an extremely thin oxide film (not illustrated) with a thickness of about several nm on the surface of the lower electrode using an $O_2$ gas, and a step of forming an upper electrode (not illustrated) containing Al on the surface of the oxide film by a vapor deposition method. The lower electrode and the upper electrode may be patterned by, for example, a lift-off method using a patterned resist mask (not illustrated). In this case, an opening pattern of the resist mask may have a cross shape including a first linear portion along a first direction and a second linear portion along a second direction orthogonal to the first direction, and the lower electrode may be formed in a portion corresponding to the first linear portion by performing vapor deposition while tilting the resist mask about the first direction as a rotation axis. Subsequently, the upper electrode may be formed in a portion corresponding to the second linear portion by performing vapor deposition while tilting the resist mask about the second direction as a rotation axis. According to the above method, it is possible to pattern the lower electrode and the upper electrode with a single resist mask.

As described above, the quantum device 100 according to the embodiment of the disclosed technique has a plurality of quantum bits 1 connected to each other via the coupling wiring lines 30. Each of the plurality of quantum bits 1 includes a Josephson junction device 4 and a quantum bit electrode 50 connected to one end of the Josephson junction device 4. The quantum device 100 includes a ground electrode 51 that extends around the quantum bit electrode 50 and is connected to the other end of the Josephson junction device 4, an insulating region 52 extending between the quantum bit electrode 50 and the ground electrode 51, and a guard structure 54 that is provided along the portion of the coupling wiring line 30 extending in the insulating region 52 and is fixed to the ground potential.

In a case in which the electrode type of the quantum bit 1 is the Grounded type, the quantum bit electrode 50 and the ground electrode 51 are preferably arranged at a certain distance or more from each other in order to mitigate electric field concentration. Therefore, an insulating region 52 is formed between the quantum bit electrode 50 and the ground electrode 51. On the other hand, in order to secure the coupling strength between the quantum bits, it is preferable to cause the coupling wiring line 30 to extend into the insulating region 52 and bring the terminal end of the coupling wiring line 30 close to the quantum bit electrode 50. In this case, the length of the portion of the coupling wiring line 30 extending in the insulating region 52 increases, and as a result, leakage of the control signal to the coupling wiring line 30 (crosstalk) becomes significant in the two-quantum gate operation. According to the quantum device 100 of the present embodiment, since the guard structure 54 fixed to the ground potential is provided along the portion of the coupling wiring line 30 extending in the insulating region 52, it is possible to suppress leakage of the control signal to the coupling wiring line 30 (crosstalk). In other words, according to the quantum device 100 according to the present embodiment, it is possible to suppress an increase in crosstalk accompanying an increase in coupling strength between quantum bits.

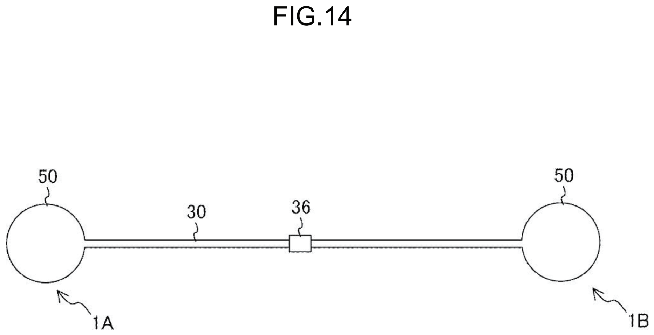

As a connection configuration between the coupling wiring line 30 and the quantum bit 1, as illustrated in Fig. 14, in the quantum bits 1A and 1B adjacent to each other, a configuration in which the coupling wiring line 30 is directly connected to the quantum bit electrode 50 is also conceivable. In this case, a capacitor 36 is provided between the two quantum bit electrodes 50 connected to the coupling wiring line 30.

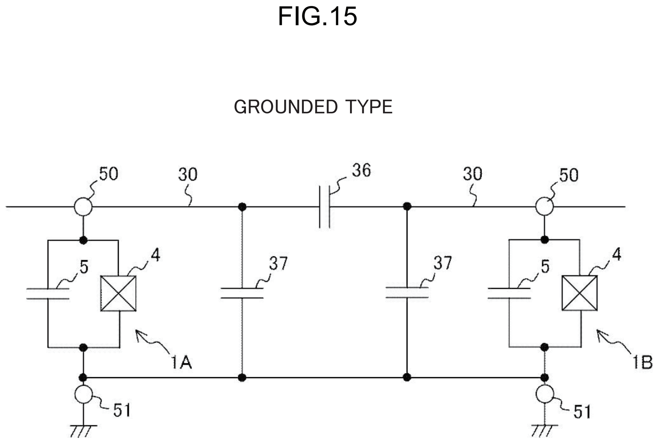

Fig. 15 is an equivalent circuit diagram corresponding to Fig. 14. According to the configuration in which the coupling wiring line 30 is directly connected to the quantum bit electrode 50, a parasitic capacitor 37 associated with the coupling wiring line 30 is formed between the quantum bit electrode 50 and the ground electrode 51. In other words, the parasitic capacitor 37 is connected in parallel to the capacitor 5 constituting the transmon of the quantum bit 1. Since the capacitance of the parasitic capacitor 37 has a large value and variation, when the parasitic capacitor 37 is connected in parallel to the capacitor 5 constituting the transmon, it is difficult to design an appropriate transmon. In other words, in a case in which the electrode type of the quantum bit 1 is the Grounded type, the connection configuration in which the coupling wiring line 30 is directly connected to the quantum bit 1 is not suitable. In the Grounded type, it is preferable to connect the coupling wiring line 30 and the quantum bit 1 via the capacitor 31.

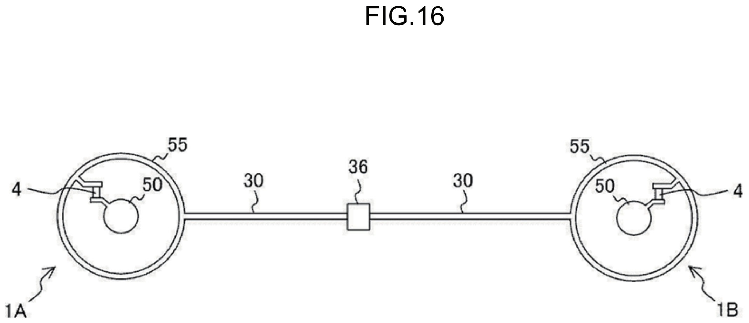

As an electrode type of a quantum bit, a Floating type has been proposed in addition to the Grounded type. Fig. 16 is a plan view illustrating an example of a connection configuration between the quantum bit 1A and the quantum bit 1B whose electrode type is a Floating type. In the Floating type, a floating electrode 55 with an annular shape is provided so as to surround the quantum bit electrode 50. The potential of the floating electrode 55 is floating. One end of the Josephson junction device 4 is connected to the quantum bit electrode 50, and the other end is connected to the floating electrode 55. The coupling wiring line 30 can be directly connected to the floating electrode 55, and a capacitor 36 is provided between the quantum bit 1A and the quantum bit 1B that are connected to the coupling wiring line 30.

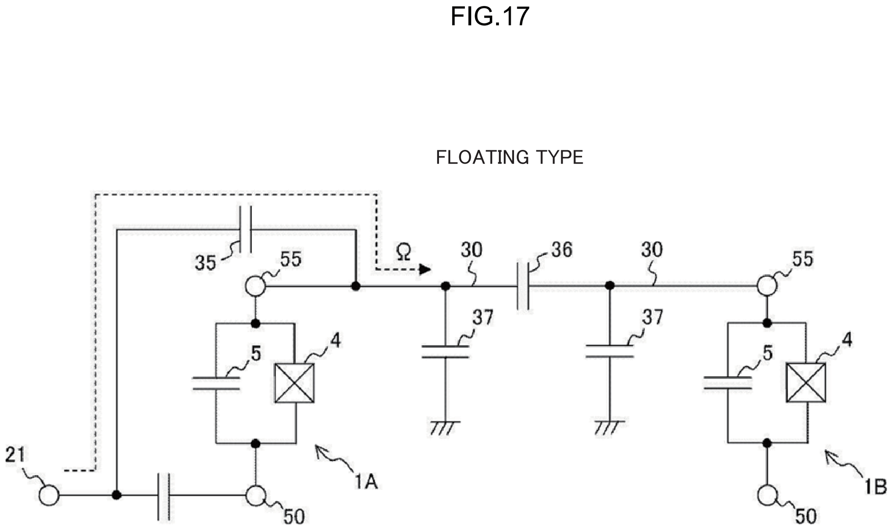

Fig. 17 is an equivalent circuit diagram corresponding to Fig. 16. In the Floating type, even if the coupling wiring line 30 is directly connected to the floating electrode 55, the parasitic capacitor 37 associated with the coupling wiring line 30 does not affect the transmon. Further, in a Concentric type, the parasitic capacitor 35 formed between the control port 21 and the coupling wiring line 30 is less likely to cause crosstalk. This is because, in the case of the Floating type, a connection destination of the parasitic capacitor 35 becomes the floating electrode 55 of the control quantum bit itself, and does not cause leakage of the control signal $\Omega$ to the target quantum bit. Therefore, in a configuration of the Floating type in which the coupling wiring line 30 is directly connected to the floating electrode 55, it is not necessary to provide a guard structure in association with the coupling wiring line 30. The guard structure is particularly effective in a configuration of the Floating type in which the coupling wiring line 30 and the quantum bit electrode 50 are connected via a capacitor.

**Claims**

1. A quantum device (100) having a plurality of quantum bits (1) connected to each other via coupling wiring lines (30), wherein

   each of the plurality of quantum bits includes:

      a Josephson junction device (4); and
      a quantum bit electrode (50) connected to one end of the Josephson junction device; and

   the quantum device comprising:

      a ground electrode (51) to which the other end of the Josephson junction device is connected;
      an insulating region (52) between the quantum bit electrode and the ground electrode; and
      a guard structure (54) that is provided along a portion of the coupling wiring line extending in the insulating region and is fixed to a ground potential.

2. The quantum device according to claim 1, wherein the guard structure is constituted by a portion protruding from an edge of the ground electrode facing the quantum bit electrode toward the quantum bit electrode.

3. The quantum device according to claim 1 or 2, wherein

the ground electrode has an open region (53) for arranging the coupling wiring line, and
the guard structure is provided so as to extend the open region to the insulating region.

4. The quantum device according to claim 2, wherein
a ratio l/g of a length l of the guard structure in a protruding direction to a distance g between the quantum bit electrode and the ground electrode is from 0.45 to 0.55.

5. The quantum device according to any one of claims 1 to 4, wherein

the quantum bit electrode has a circular shape with a radius of $r_1$, and
an edge of the ground electrode facing the quantum bit electrode has a circular shape that is concentric with the quantum bit electrode and has a radius of $r_2$, and
a radius ratio $r_2/r_1$ is 2 or more.

6. The quantum device according to any one of claims 1 to 5, wherein
the coupling wiring line is connected to the quantum bit electrode via a capacitor (31).

7. The quantum device according to any one of claims 1 to 6, comprising:

a substrate having the plurality of quantum bits and the coupling wiring line on a first surface (S1); and
a control port (21) that is provided at a position corresponding to the quantum bit electrode on a second surface (120) of the substrate opposite to the first surface, and to which a control signal for controlling the quantum bit is input.

8. A method for manufacturing a quantum device having a plurality of quantum bits connected to each other via coupling wiring lines, the method comprising:

forming a Josephson junction device on a first surface of a substrate;
forming a quantum bit electrode connected to one end of the Josephson junction device on the first surface of the substrate;
forming, on the first surface of the substrate, a ground electrode to which the other end of the Josephson junction device is connected; and
forming a guard structure fixed to a ground potential along a portion of the coupling wiring line extending in an insulating region formed between the quantum bit electrode and the ground electrode.

9. The manufacturing method according to claim 8, wherein
the guard structure is constituted by a portion protruding from an edge of the ground electrode facing the quantum bit electrode toward the quantum bit electrode.

10. The manufacturing method according to claim 8 or 9, wherein

the ground electrode has an open region for arranging the coupling wiring line, and
the guard structure is provided so as to extend the open region to the insulating region.

11. The manufacturing method according to claim 9, wherein
a ratio l/g of a length l of the guard structure in a protruding direction to a distance g between the quantum bit electrode and the ground electrode is from 0.45 to 0.55.

12. The manufacturing method according to any one of claims 8 to 11, wherein

the quantum bit electrode has a circular shape with a radius of $r_1$, and
an edge of the ground electrode facing the quantum bit electrode has a circular shape that is concentric with the quantum bit electrode and has a radius of $r_2$, and
a radius ratio $r_2/r_1$ is 2 or more.

13. The manufacturing method according to any one of claims 8 to 12, wherein

the coupling wiring line is connected to the quantum bit electrode via a capacitor.

**14.** The manufacturing method according to any one of claims 8 to 13, comprising:
forming a control port to which a control signal for controlling the quantum bit is input, at a position corresponding to the quantum bit electrode, on a second surface of the substrate opposite to the first surface.

## FIG.1

# FIG.2

FIG.3

EP 4 788 108 A1

# FIG.4

# FIG.5

FIG.6

# FIG.7A

# FIG.7B

FIG.8

EP 4 788 108 A1

# FIG.9

# FIG.10

# FIG.11

## FIG.12

ELECTRIC FIELD APPLICATION
FROM CONTROL PORT

ELECTRIC FIELD APPLICATION
FROM QUANTUM BIT ELECTRODE

ELECTRIC FIELD INTENSITY (STANDARD VALUE)

DISTANCE FROM CENTER OF QUANTUM BIT ELECTRODE [μm]

EP 4 788 108 A1

FIG.13A

120

# FIG.13B

60

# FIG.13C

# FIG.13D

FIG.14

# FIG.15

GROUNDED TYPE

FIG.16

FIG.17

FLOATING TYPE

EP 4 788 108 A1

Europäisches
Patentamt
European
Patent Office
Office européen
des brevets

## EUROPEAN SEARCH REPORT

**Application Number**

EP 26 15 3191

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | COLLODO M C ET AL: "Implementation of Conditional-Phase Gates based on tunable ZZ-Interactions", ARXIV.ORG CORNELL UNIVERSITY LIBRARY, 201 OLIN LIBRARY CORNELL UNIVERSITY ITHACA, NY 14853, 18 May 2020 (2020-05-18), XP081672098, | 1-4,6, 8-11,13 | INV. H10N60/01 H10N60/80 H10N69/00 |
| A | * page 1 - page 3; figure 1 * | 5,7,12, 14 | |
| A | US 2022/293844 A1 (MARTIN Y [US] ET AL) 15 September 2022 (2022-09-15) * paragraph [0087] - paragraph [0089]; figures 31-35 * | 1-14 | |

**TECHNICAL FIELDS SEARCHED (IPC)**

H10N

The present search report has been drawn up for all claims

| Place of search | Date of completion of the search | Examiner |
|---|---|---|
| Munich | 6 May 2026 | Carmiggelt, Joris |

EPO FORM 1503 03.82 (P04C01)

## ANNEX TO THE EUROPEAN SEARCH REPORT
## ON EUROPEAN PATENT APPLICATION NO.

EP 26 15 3191

This annex lists the patent family members relating to the patent documents cited in the above-mentioned European search report.
The members are as contained in the European Patent Office EDP file on
The European Patent Office is in no way liable for these particulars which are merely given for the purpose of information.

06-05-2026

| Patent document cited in search report | Publication date | Patent family member(s) | | Publication date |
|---|---|---|---|---|
| US 2022293844 A1 | 15-09-2022 | AU | 2022233255 A1 | 17-08-2023 |
| | | CN | 116964597 A | 27-10-2023 |
| | | EP | 4305557 A1 | 17-01-2024 |
| | | JP | 2024510078 A | 06-03-2024 |
| | | US | 2022293844 A1 | 15-09-2022 |
| | | WO | 2022189511 A1 | 15-09-2022 |

EPO FORM P0459

For more details about this annex : see Official Journal of the European Patent Office, No. 12/82

**EP 4 788 108 A1**

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021245949 A
- JP 2023063931 A